# FASCICULE DE BREVET EUROPEEN

(11) **EP 3 818 566 B1**
(45) Date de publication et mention de la délivrance du brevet: **15.06.2022**
(21) Numéro de dépôt: 19732639.0
(22) Date de dépôt: 21.06.2019
(51) Int. Cl.: H01L 27/146

(54) **DÉTECTEUR BI-SPECTRAL AMÉLIORÉ**
VERBESSERTER BISPEKTRALER DETEKTOR
IMPROVED BI-SPECTRAL DETECTOR

(30) Priorité: 05.07.2018 FR 1800717
(43) Date de publication de la demande: 12.05.2021
(73) Titulaire: THALES, 92400 Courbevoie (FR); Commissariat à l'Energie Atomique et aux Energies Alternatives, 75015 Paris (FR)
(72) Inventeur: DELGA, Alexandre, 91767 Palaiseau Cedex (FR); REVERCHON, Jean-Luc, 91767 Palaiseau Cedex (FR)
(74) Mandataire: Marks & Clerk France
(86) Numéro de dépôt international: PCT/EP2019/066468
(87) Numéro de publication internationale: WO 2020/007622

(56) Documents cités:
- EP-A2- 2 180 511
- US-A1- 2016 322 516
- A ROGALSKI: "Infrared detectors: an overview", INFRARED PHYSICS & TECHNOLOGY, vol. 43, no. 3-5, 1 juin 2002 (2002-06-01) , pages 187-210, XP055007585, ISSN: 1350-4495, DOI: 10.1016/S1350-4495(02)00140-8

## Description

### DOMAINE DE L'INVENTION

L'invention concerne un détecteur bi-spectral amélioré, pour les domaines de l'imagerie infrarouge IR. Plus particulièrement l'invention concerne un détecteur bi-spectral, c'est-à-dire sensible dans deux bandes spectrales IR, par exemple dans la bande MWIR (Médium Wavelength Infra Red en anglais) typiquement comprise entre 3 µm et 5 µm et dans la bande LWIR (Long Wavelength Infra Red en anglais) typiquement comprise entre 8 µm et 12 µm.

### ETAT DE LA TECHNIQUE

Dans l'imagerie infrarouge thermique, on distingue principalement deux gammes de longueur d'onde bénéficiant de la transmission de l'atmosphère :
- le moyen infrarouge ou MWIR de 3 à 5µm, lui-même subdivisé en deux fenêtres de part et d'autre de la bande d'absorption du CO₂. L'émission du corps noir varie fortement avec la température et la transmission est moins perturbée par l'humidité.
- le lointain infrarouge ou LWIR de 8 à 12µm. Il correspond au pic d'émission d'un corps noir à température ambiante. Il est peu sensible aux phénomènes de diffusion de la lumière.

Chacune de ses deux fenêtres présente donc des avantages en fonction des conditions opérationnelles (zone maritime, côtière, désertique...) au-delà des qualités intrinsèques des imageurs permettant d'adresser ces deux gammes de longueur d'onde (uniformité, détectivité...).

Aussi, une offre basée sur une caméra bi-spectrale MWIR/LWIR est proposée dans les années 2000.

Selon une première technologie dénommée matrice de Bayer, le détecteur comprend une couche semi-conductrice absorbante simultanément dans les deux bandes IR, et des filtres interférentiels sont disposés sur les pixels pour détecter une image LWIR Im_{L} et une image MWIR Im_{M}. La réalisation de ces filtres est complexe, la sensibilité et la résolution sont faibles, et les deux images I_{ML} et Im_{M} récupérées par le détecteur ne présentent pas de cohérence spatiale.

On entend par cohérence spatiale entre les deux images le fait que la lumière incidente sur un même pixel de chaque image provienne de la même zone de la scène. Les pixels LWIR et MWIR étant ici adjacents, il ne peut y avoir de cohérence spatiale entre les deux images.

La détection de deux images cohérentes présente l'intérêt de pouvoir comparer précisément la signature MWIR et LWIR d'un élément de la scène qui ne s'étend parfois que sur quelques pixels.

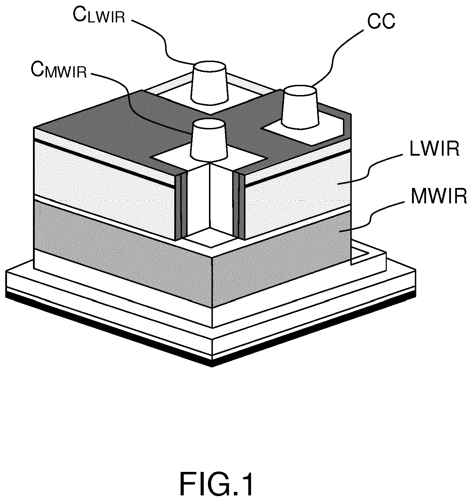

Une deuxième technologie permettant de conserver la cohérence spatiale est basée sur un détecteur comprenant deux couches absorbantes superposées, une sensible dans le LWIR et une dans le MWIR, tel qu'illustré figure 1.

Dans cet exemple chaque étage est constitué d'un QWIP (pour « Quantum Well Infrared Photodetector » en anglais) à base de GaAs/AlGaAs. Le pixel présente une structure en mésa correspondant à une gravure des couches actives pour délimiter le pixel, celles-ci se retrouvant alors en contact avec l'air. Il convient dans ce type de structure de prendre un contact par couche (C_{LWIR} et C_{MWIR}) et un contact commun CC. Préférentiellement ces trois contacts sont reportés sur un même plan, pour faciliter le raccordement au circuit de lecture.

La technologie QWIP est une technologie de type inter sous bande (ISB) dans laquelle les photo-porteurs sont générés d'une sous bande de la bande de conduction vers une autre sous bande de la bande de conduction.

Les principaux problèmes rencontrés sont un mauvais couplage optique de l'étage MWIR compromettant le rendement quantique critique dans la gamme MWIR. Des problématiques de diaphonie optique à travers le contact commun ont compliqué la réalisation.

De manière générale la mise en œuvre de deux prises de contacts est délicate au niveau matriciel pour ces structures à deux étages.

Pour un pixel en mésa, le contact entre la couche active et l'air crée un courant d'obscurité, ceci étant particulièrement critique pour les détecteurs fondés sur la détection inter bande, c'est-à-dire par génération de photo-porteurs de la bande de valence vers la bande de conduction. On citera à titre d'exemple un capteur en super-réseaux de type II sur GaSb présentant une structure mésa sur au moins un niveau. Pour les détecteurs basés sur la détection inter bande il convient donc de passiver la structure mesa, ce qui pose des problèmes technologiques.

Ainsi, aucune des approches pour l'imagerie bi-spectrale IR selon l'état de la technique n'a vraiment réussi à s'imposer pour des raisons de complexité de l'optique et du détecteur.

Les documents A. ROGALSKI ("Infrared detectors: an overview",INFRARED PHYSICS & TECHNOLOGY, vol. 43, no. 3-5, 1 juin 2002 (2002-06-01), pages 187-210, XP055007585,ISSN: 1350-4495, DOI: 10.1016/ S1350-4495(02)00140-8) et US 2016/322516 décrivent des détecteurs optiques selon l'art antérieure.

Un but de la présente invention est de pallier certains inconvénients précités en proposant un détecteur bi-spectral amélioré présentant une technologie simplifiée, une meilleure résolution et/ou FTM (Fonction de Transfert de Modulation), et/ou un meilleur gain et/ou une meilleure sensibilité.

### DESCRIPTION DE L'INVENTION

La présente invention a pour objet un détecteur optique sensible dans au moins deux plages de longueur d'onde infrarouges dénommées première bande spectrale et deuxième bande spectrale, et présentant un ensemble de pixels, comprenant :
- une structure absorbante disposée sur une face inférieure d'un susbtrat et comprenant un empilement d'au moins une couche absorbante en matériau semi-conducteur, sensible dans les deux bandes spectrale et apte à photo-générer des porteurs par absorption d'un faisceau incident sur une face supérieure dudit substrat, la structure absorbante étant en outre reliée à un circuit de lecture par au moins un ensemble de contacts associés auxdits pixels,
- le détecteur comprenant en outre une pluralité de résonateurs diélectriques sur la face supérieure dudit substrat formant une surface supérieure dénommée meta-surface, la meta-surface étant configurée pour diffuser, défléchir et focaliser dans les pixels du détecteur de manière résonnante, lorsqu'éclairée par la lumière incidente, un premier faisceau présentant au moins une première longueur d'onde comprise dans la première bande spectrale et un deuxième faisceau présentant au moins une deuxième longueur d'onde comprise dans la deuxième bande, la meta-surface étant en outre configurée pour que lesdits premier et deuxième faisceaux soient focalisés sur des pixels différents du détecteur.

Avantageusement la première bande spectrale est comprise dans la bande 3-5 µm et la deuxième bande spectrale est comprise dans la bande 8-12 µm.

Selon une première variante l'empilement comprend une seule couche absorbante sensible à la fois dans la première et la deuxième bande spectrale, le premier faisceau étant focalisé sur un premier sous ensemble de pixels dénommés premiers pixels, et le deuxième faisceau étant focalisé sur un deuxième sous ensemble de pixels dénommés deuxièmes pixels, lesdits premier et deuxième pixels étant disposés dans un même plan.

Selon une deuxième variante l'empilement comprend une première couche absorbante sensible dans la première bande spectrale et disposée dans un premier plan, et une deuxième couche absorbante sensible dans la deuxième bande spectrale et disposée dans un deuxième plan différent du premier plan, la première couche absorbante étant la plus proche du substrat, le premier faisceau étant focalisé sensiblement dans le premier plan sur un premier sous ensemble de pixels dénommés premiers pixels, et le deuxième faisceau étant focalisé sensiblement dans le deuxième plan sur un deuxième sous ensemble de pixels dénommés deuxièmes pixels.

Selon un mode de réalisation la deuxième couche absorbante est discontinue et gravée de sorte qu'un deuxième pixel présente une structure en mésa. Préférentiellement la deuxième couche absorbante réalise une détection inter sous bande.

Selon un mode de réalisation un deuxième pixel comprend un réseau de diffraction configuré pour diffracter en réflexion le deuxième faisceau.

Selon une sous variante la première couche absorbante est continue. Avantageusement la première couche absorbante (AL1) réalise une détection inter bande.

Selon un mode de réalisation chaque premier pixel (Pix1) est relié à un premier contact et chaque deuxième pixel est relié à un deuxième contact, et une structure en mesa d'un deuxième pixel sur deux est utilisée comme pilier de manière à rapporter les premiers contacts sur sensiblement un même plan horizontal que les deuxièmes contacts.

Selon un mode de réalisation chaque premier pixel est relié à un premier contact et chaque deuxième pixel est relié à un deuxième contact, et la première couche absorbante est discontinue et gravée de sorte que chaque premier pixel présente une structure en mésa servant de base à la structure en mésa du deuxième pixel.

Selon un mode de réalisation une structure en mesa d'un deuxième pixel sur deux est utilisée comme pilier (15) de manière à rapporter le premier contact (CL1) sur sensiblement un même plan horizontal que le deuxième contact (CL2).

Selon un mode de réalisation on définit une première meta-lentille comme la fraction de la meta-surface focalisant le premier faisceau dans un premier pixel associé, et une deuxième meta-lentille comme la fraction de la meta-surface focalisant le deuxième faisceau dans un deuxième pixel associé, et dans lequel la meta-surface est configurée de sorte que les premières et les deuxièmes meta-lentilles soient décalées l'une par rapport à l'autre.

Selon un autre mode de réalisation on définit une première meta-lentille comme la fraction de la metasurface focalisant le premier faisceau dans un premier pixel associé, et une deuxième meta-lentille comme la fraction de la metasurface focalisant le deuxième faisceau dans un deuxième pixel associé, et dans lequel la meta-surface est configurée de sorte que les premières et deuxième meta-lentilles soient superposées. Préférentiellement la somme des surfaces respectives d'un premier et d'un deuxième pixel est inférieure ou égale à la surface d'une meta-lentille.

D'autres caractéristiques, buts et avantages de la présente invention apparaîtront à la lecture de la description détaillée qui va suivre et en regard des dessins annexés donnés à titre d'exemples non limitatifs et sur lesquels :
La figure 1, déjà citée, illustre un détecteur bi-spectral avec pixel en mésa selon l'état de la technique.
Le figure 2 illustre une première variante de détecteur selon l'invention à un seul niveau combinée à un agencement des meta-lentilles en mode décalé.
La figure 3 illustre des exemples de formes de résonateurs selon l'invention,
la figure 3a illustre un résonateur de forme ronde et la figure 3b illustre un résonateur de forme carrée.
La figure 4 illustre un agencement de meta-lentille de type entrelacé appliqué à la première variante du détecteur selon l'invention, en vue de dessus.
La figure 5 illustre une première variante de détecteur selon l'invention à un seul niveau combinée à un agencement des meta-lentilles en mode superposé.
La figure 6 illustre un agencement de meta-lentille de type superposé du détecteur selon l'invention, combinée à un agencement de type « dilué » des pixels, en vue de dessus.
La figure 7 illustre la sous variante à première couche absorbante continue d'une deuxième variante de détecteur selon l'invention à deux niveaux, combinée à un agencement de type décalé des meta-lentilles et présentant une géométrie de contact simplifiée, tous les contacts étant rapportés sur un même plan.
La figure 8 illustre la sous variante à première couche absorbante continue de la deuxième variante de détecteur selon l'invention à deux niveaux, combinée à un agencement de type superposé des meta-lentilles et présentant une géométrie de contact simplifiée, tous les contacts étant rapportés sur un même plan.
La figure 9 illustre la sous variante à première couche absorbante continue de la deuxième variante de détecteur selon l'invention à deux niveaux, combinée à un agencement de type superposé des meta-lentilles et présentant un agencement de type « dense » des pixels.
La figure 10 illustre un agencement de meta-lentille de type superposé du détecteur selon l'invention, combinée à un agencement de type « dense » des pixels, en vue de dessus.
La figure 11 illustre la sous variante à double mésa de la deuxième variante de détecteur selon l'invention à deux niveaux, combinée à un agencement de type superposé des meta-lentilles et présentant un agencement de type « dilué » des pixels.

### DESCRIPTION DETAILLEE DE L'INVENTION

L'invention concerne un détecteur optique 10 sensible dans au moins deux plages de longueur d'onde infra rouge dénommées première bande spectrale SB1 et deuxième bande spectrale SB2, communément dénommé détecteur bi-spectral.

Selon un mode de réalisation préféré la première bande spectrale SB1 est comprise dans la bande 3-5 µm MWIR et la deuxième bande spectrale SB2 est comprise dans la bande 8-12 µm LWIR.

Et d'autres configurations bi-spectrales sont possibles, telles :
- MWIR « bleu » autour de 4.2 µm et MWIR « rouge » autour de 4.8 µm, c'est-à-dire de part et d'autre de la bande d'absorption du CO₂ (pour faciliter la détection de points chauds par exemple),
- LWIR [8-10µm] et LWIR [10-12µm],
- MWIR et proche infrarouge (dit SWIR).

Le détecteur bi-spectral selon l'invention comprend un ensemble de pixels, préférentiellement agencés sous forme de matrice, subdivisé en un premier sous ensemble de pixels dénommés premiers pixels Pix1 configurés pour détecter un signal lumineux dans SB1, et un deuxième sous ensemble de pixels dénommés deuxièmes pixels Pix2 configurés pour détecter un signal lumineux dans SB2.

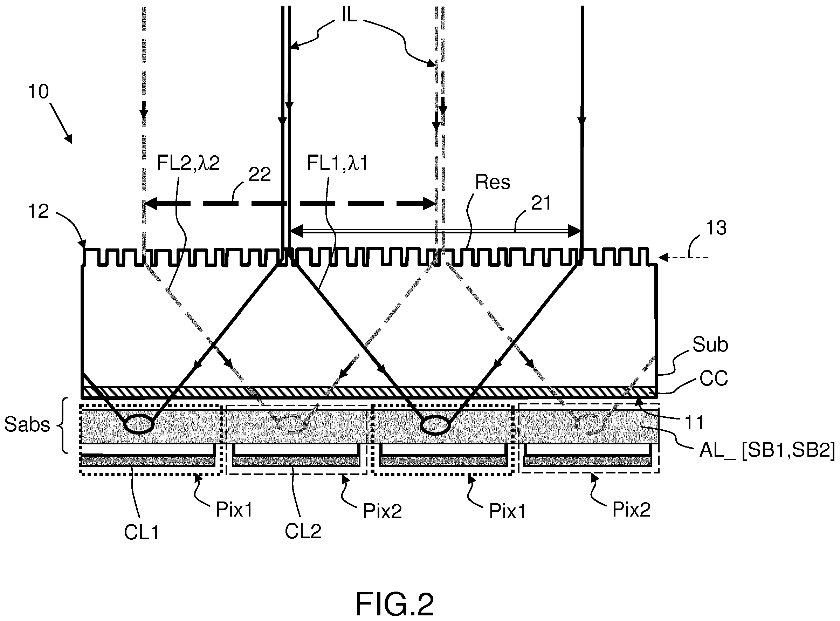

Différentes variantes du détecteur 10 selon l'invention sont illustrées figures 2, 5, 7, 8, 9 et 11 qui seront décrites séparément plus loin.

Il comprend une structure absorbante Sabs disposée sur une face inférieure 11 d'un substrat Sub comprenant un empilement d'au moins une couche absorbante en matériau semi-conducteur, également dénommée couche active, l'empilement étant sensible dans les deux bandes spectrale SB1, SB2 et apte à photo-générer des porteurs par absorption d'un faisceau lumineux incident IL sur une face supérieure 12 du substrat Sub. Typiquement l'épaisseur du substrat est comprise entre quelques dizaines à quelques centaines de µm et le matériau du substrat est choisi parmi : InP, GaAs, GaSb, Si, SiC, Diamant.

La structure absorbante comprend typiquement, outre la ou les couches actives, plusieurs autres couches (non représentées) telles des couches d'injection de porteurs.

Une couche active peut être constituée d'un grand nombre de sous couches, telles des multi-puis quantiques ou des super-réseaux. Des exemples de matériau semi-conducteur pour la couche absorbante sont: InGaAs ; InAsSb ; super réseau InAsSb/InAs ; InSb ; super réseau GaSb/InAs ; GaN ; AlGaN, AlGaAsSb ; multi-puits quantiques GaAs/AlGaAs ou InGaAs/AlInAs, super-réseau InAs/AlSb.

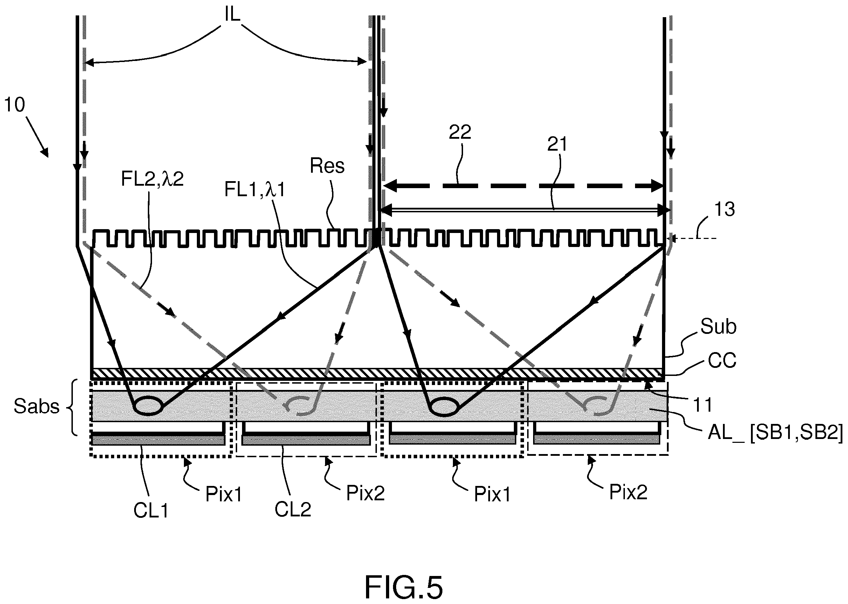

Dans une première variante illustrée figures 2 et 5, l'empilement comprend une seule couche absorbante AL sensible à la fois dans la première bande spectrale SB1 et la deuxième bande spectrale SB2.

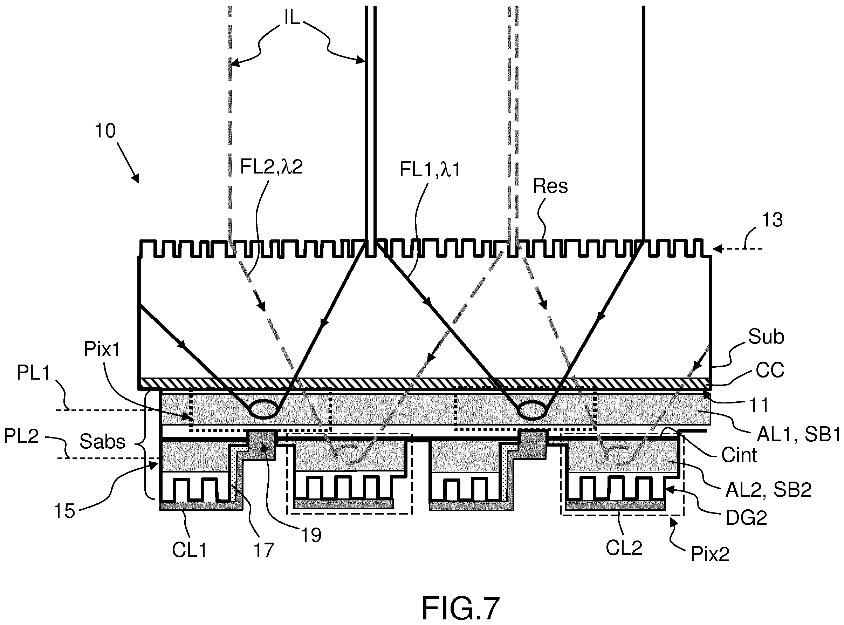

Dans une deuxième variante illustrée figures 7, 8, 9 et 11, l'empilement comprend une première couche absorbante AL1 sensible dans la première bande spectrale SB1 disposée dans un premier plan PL1, et une deuxième couche absorbante AL2 sensible dans la deuxième bande spectrale SB2 disposée dans un deuxième plan PL2 différent du premier plan. Les deux plans PL1 et PL2 sont superposés. Par convention la première couche absorbante AL1 est la plus proche du substrat.

La structure absorbante est en outre reliée à un circuit de lecture (non représenté sur les figures) via au moins un ensemble de contacts associés aux pixels, et il existe en outre un contact commun à tous les pixels CC, par exemple constitué d'une zone très dopée à l'extrémité du substrat située du côté de la couche absorbante AL ou AL1.

Le détecteur selon l'invention comprend en outre un ensemble de résonateurs diélectriques Res sur la face supérieure 12 du substrat Sub formant une surface supérieure dénommée meta-surface 13 .

Lorsqu'elle est éclairée par le faisceau incident IL, la meta-surface 13 est configurée pour diffuser de manière résonnante et focaliser dans les pixels du détecteur, un premier faisceau lumineux FL1 présentant au moins une première longueur d'onde λ1 comprise dans la première bande spectrale SB1 et un deuxième faisceau lumineux FL2 présentant au moins une deuxième longueur d'onde λ2 comprise dans la deuxième bande spectrale SB2.

La meta-surface est en outre configurée pour que le premier faisceau FL1 et le deuxième faisceau FL2 soient focalisés sur des pixels différents du détecteur, elle sépare spatialement les deux longueurs d'onde λ1, λ2.

Le premier faisceau FL1 est focalisé sur un premier sous ensemble de pixels constitué de premiers pixels Pix1, et le deuxième faisceau FL2 est focalisé sur un deuxième sous ensemble de pixels constitué de deuxièmes pixels Pix2. La meta-surface 13 permet donc de focaliser le flux incident sur les pixels voulus.

Pour la première variante du détecteur selon l'invention illustrée figures 2 et 5 les premier et deuxième pixels sont disposés dans un même plan, le détecteur ne présente qu'un seul niveau. La sélectivité spectrale s'opère par « tri de photon » (« photon sorting »en anglais) au moyen de la meta-surface.

On définit des contacts CL1 associés aux pixels Pix1 et des contacts CL2 associés aux pixels Pix2.

Le circuit de lecture reconstitue, à partir du faisceau incident IL provenant d'une scène, une image Im1 à SB1 provenant des pixels Pix1, et une image Im2 à SB2 provenant des pixels Pix2, à partir de signaux électriques issus des photo-porteurs arrivant respectivement sur les contacts CL1 et CL2. Pour la première variante, la couche AL étant sensible dans les deux bandes spectrales, c'est la meta-surface 13 qui détermine les pixels Pix1 qui détectent l'image Im1 et les pixels Pix2 qui détectent l'image Im2.

Les résonateurs Res de la meta-surface 13 sont soit gravés directement dans le substrat Sub (dans ce cas ils ne présentent pas de différence d'indice avec le substrat) soit réalisés sur une autre surface rapportée sur le substrat.

De manière générale cet ensemble de résonateurs forme une meta-surface de Huygens qui agit sur la lumière incidente de manière à réaliser une ou plusieurs fonctions optiques. Ces éléments constituent une monocouche de nano-antennes diélectriques qui fonctionnent de façon résonnante, exaltant la réponse au voisinage d'une fréquence de résonance λ_{R} (largueur spectrale de la résonance centrée sur λ_{R}) tout en coupant le flux lumineux autour de cette largeur spectrale de résonance. Chaque résonateur est un dipôle rayonnant ou dipôle de Huygens et un nombre important de modes d'antenne sont accessibles en jouant sur la forme, la taille et l'agencement de ces dipôles. Ils composent un assemblage de nano-antennes dont les dimensions et l'espacement sont de l'ordre de grandeur de la longueur d'onde de résonance, ou sub-longueur d'onde. Chaque résonateur imprime une phase spécifique au signal incident, phase contrôlée à la fois dans SB1 et SB2.

Plus généralement chaque nano-antenne peut être vue comme une valeur locale d'impédance de surface aux deux longueurs d'onde λ1 et λ2.

Les résonateurs jouent le rôle de microlentilles convergentes permettant de focaliser la lumière incidente dans une bande spectrale autour de la longueur d'onde de résonance, au plus près du contact du pixel. Le profil effectif de la lentille est contrôlé par la disposition des antennes.

Comparé aux structures optiques de type indice effectif (type lentille de Fresnel digitalisée) le principe physique diffère : le front d'onde est modelé du fait d'une phase conférée de manière abrupte, sur une distance très courte devant la longueur d'onde, et non accumulée le long du chemin optique. Un photon incident sur un point de la microlentille est capté par une nano antenne précise, interagit avec elle et est réémis avec une phase donnée. Les profils de lentille accessibles sont plus variés que pour les structures à indice effectif et on contrôle de manière très précise la focale de la lentille, qui peut être très courte.

La meta-surface de l'invention est configurée pour résonner simultanément à λ1 et λ2 (avec respectivement une largeur spectrale autour de ces deux longueurs d'onde). La capacité d'une même meta-surface à focaliser, c'est-à-dire résonner simultanément sur plusieurs longueurs d'ondes a été démontrée pour des longueurs d'onde télécoms, avec cofocalisation de 3 longueurs d'ondes dans la publication Aieta et al : « Multiwavelength achromatic metasurfaces by dispersive phase compensation » Science, 347 (6228), 1342-1345 (2015). La focalisation s'effectue au moyen d'une assemblée de *résonateurs hybrides* formés de plusieurs sous résonateurs couplés. Ainsi, l'ingénierie du couplage permet d'obtenir le profil d'impédance voulu à plusieurs longueurs d'ondes de résonance.

Les dimensions des résonateurs sont inférieures aux dimensions des pixels du détecteur. On dénomme première meta-lentille ML1 la fraction de la meta-surface 13 focalisant le premier faisceau FL1 dans un premier pixel Pix1 associé, et deuxième meta-lentille ML2 la fraction de la meta-surface focalisant le deuxième faisceau FL2 dans un deuxième pixel Pix2 associé. Par exemple sur les figures 2 et 5 les flèches 21 et 22 illustrent respectivement la dimension de la pupille de ML1 et de ML2. Chaque meta-lentille est constituée d'une pluralité de résonateurs, typiquement au moins 5x5 résonateurs.

Typiquement au moins une dimension d'un résonateur Res, choisie parmi largueur, longueur, hauteur, est comprise dans l'intervalle [λ_{R}/2n - 50% ; λ_{R}/2n + 50%] ou dans l'intervalle [ λ_{R}/n - 50% ; λ_{R}/n + 50% ], avec :
λ_{R} longueur d'onde de résonance = λ1 ou λ2,
n indice du matériau dans lequel sont gravés les résonateurs.

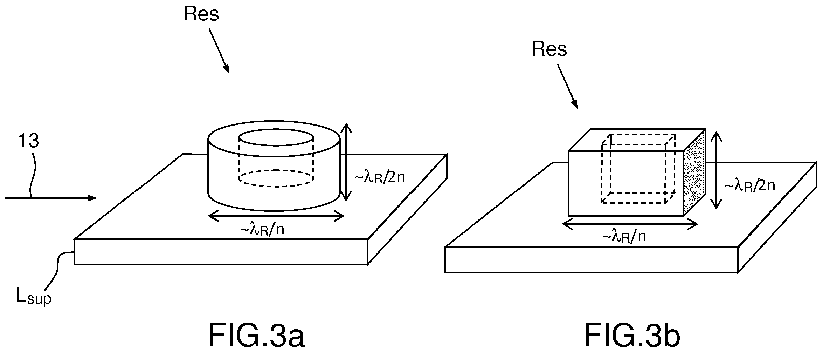

La figure 3 illustre deux exemples de motif de base de résonateurs Res selon l'invention. Typiquement ils présentent une forme circulaire (figure 3a) ou rectangulaire (figure 3b). Ils peuvent être sous forme de parois, le centre étant creux, ou pleins.

Selon la fonction optique souhaitée, des sous motifs peuvent être gravés dans le motif de base constituant le résonateur, comme les trous au centre des structures des figures 3a et 3b, constituant des sous motifs.

Grâce à la meta-surface, on limite drastiquement les phénomènes de diaphonie optique et électrique (« cross talk »), on augmente la sensibilité du capteur ou on permet une diminution de la taille des pixels en maintenant une sensibilité acceptable.

En outre l'utilisation de résonateurs selon l'invention permet de réaliser les microlentilles avec une technologie simple en une seule étape, et dont les motifs sont plus larges que ceux nécessaires pour des lentilles de Fresnel digitalisées.

Pour la première variante illustrée figures 2 et 5, grâce à la meta-surface selon l'invention les filtres diélectriques sont supprimés, ce qui simplifie grandement le procédé de fabrication du détecteur. De plus le détecteur ainsi réalisé ne présente qu'un seul niveau de contact, d'où une fabrication largement simplifiée.

Pour la couche absorbante AL sensible dans SB1 et SB2, avec SB1 comprise dans MWIR et SB2 comprise dans LWIR, selon une option on utilise un matériau semi-conducteur avec un « gap » dans le LWIR, tout en prenant garde à ce que le substrat n'absorbe ni dans le LWIR ni dans le MWIR. Il est aminci le cas échéant. La sensibilité de la couche détectrice AL couvre SB1 - SB2 et la plage entre les deux (couche AL dite large bande). Par exemple elle est réalisée en MCT ou avec un super-réseau.

Selon une autre option la sensibilité de la couche est bi-spectrale, obtenue par exemple avec un détecteur à cascade quantique dit QCD (pour « Quantum Cascade Detector » en anglais) bi-spectral, ou avec une structure hybride QW/QCD. Ici les longueurs d'ondes hors résonances, non focalisées, traversent la couche sans engendrer un signal de fond car elles ne sont pas « vues » par la couche AL.

Les meta-lentilles ML1 forment un premier sous ensemble de meta-lentilles constituant un premier réseau bidimensionnel, et les meta-lentilles ML2 forment un deuxième sous ensemble constituant un deuxième réseau bidimensionnel de meta-lentilles. Les deux réseaux peuvent s'agencer entre eux de différentes manières.

Selon un mode de réalisation illustré figure 2 les meta-lentilles ML1 et ML2 sont agencées selon un mode décalé.

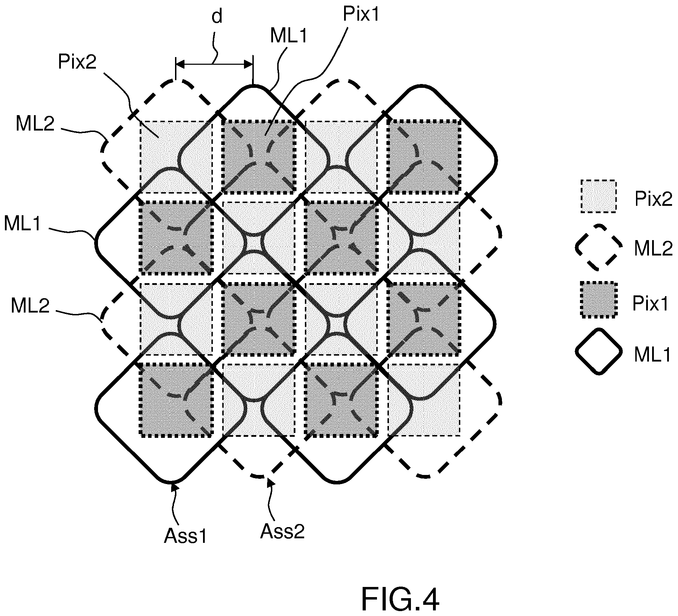

Une vue de dessus d'un exemple d'agencement décalé (interlacé) adapté à la première variante à un seul niveau est illustré figure 4. Dans cet exemple les pixels sont carrés, les meta-lentilles présentent des pupilles sensiblement carrées et décalées de 45° par rapport aux carrés formant les pixels, et le premier et le deuxième réseau de meta-lentilles sont décalés selon une dimension du carré des pixels d'une distance d correspondant à la distance entre deux pixels dans cette même dimension. On ne perd aucun flux incident, et la perte de résolution spatiale est moitié moindre que dans les configurations « diluées » décrites ci-après.

Selon un mode de réalisation illustré figure 5 la meta-surface est configurée de sorte que les premières et deuxièmes meta-lentilles soient superposées. Les meta-lentilles ML1 et ML2 fonctionnent alors hors d'axe et sont imbriquées l'une dans l'autre. Dans ce cas la lumière atteignant deux pixels Pix1 et Pix2 adjacents et respectivement associés à ML1 et ML2 superposées provient du même point de la scène. On dit alors qu'il y a cohérence spatiale entre les deux images Im1 et Im2 respectivement détectées par le premier sous ensemble de premiers pixels et le deuxième sous ensemble de deuxièmes pixels. La cohérence spatiale entre les deux images im1 et Im2 permet de détecter la signature bi-spectrale de très petites zones dans la scène.

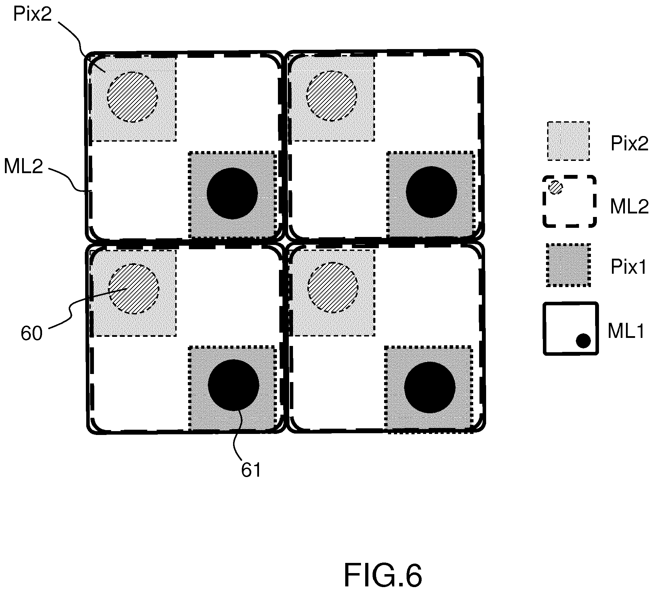

La figure 6 illustre un agencement entre pixels Pix1, Pix2 et meta-lentilles ML1, ML2 compatible avec un agencement superposé des meta-lentilles. Cet agencement est dénommé « dilué » car la surface des pixels est inférieure à la surface d'une meta-lentille. Les points 60 et 61 représentent schématiquement respectivement le focus de ML1 et de ML2.

Typiquement la somme des surfaces respectives d'un premier et d'un deuxième pixel est inférieure ou égale à la surface d'une meta-lentille.

Le fait de réaliser un pixel avec une surface «électrique » (surface de détection) inférieure à la surface « optique » (pupille) de la meta-lentille présente l'avantage d'augmenter le rapport signal sur bruit lorsque le composant est limité par le bruit d'obscurité : le signal correspondant à la surface optique, et le bruit à la surface électrique.

Selon la deuxième variante du détecteur selon l'invention les couches AL1 et AL2 sont séparées, superposées, et situées dans deux plans différents PL1 et PL2 (empilement vertical). La sensibilité de AL1 et AL2 est alors optimisée pour respectivement SB1 et SB2.

Le faisceau FL1 est focalisé sensiblement dans PL1 sur le premier sous ensemble de pixels Pix1 et FL2 est focalisé sensiblement dans PL2 sur le deuxième sous ensemble de pixels Pix2. Les distances focales des meta-lentilles ML1 et ML2 sont ajustées pour focaliser dans la couche associée et sont donc différentes. Chaque couche AL1, AL2 présente une sensibilité optimisée indépendamment de l'autre et est donc plus performante qu'une couche AL large bande ou bi-spectrale. Dans cette deuxième variante il est nécessaire de réaliser deux niveaux de contact

Préférentiellement la deuxième couche absorbante AL2 est discontinue et gravée de sorte qu'un deuxième pixel Pix2 présente une structure en mésa, tel qu'illustré figures 7, 8, 9 et 11 pour permettre la prise de contact intermédiaire. Pour ce type de structure il est préférable que la deuxième couche absorbante AL2 réalise une détection inter sous bande dite ISB facile à passiver, par exemple du type QWIP ou QCD.

Selon un mode de réalisation chaque deuxième pixel Pix2 comprend un réseau de diffraction DG2 configuré pour diffracter en réflexion le deuxième faisceau FL2. Ce réseau est situé sur le sommet du mésa du côté opposé à celui par lequel arrive le flux de lumière, soit du côté du circuit de lecture (non représenté sur les figures). Selon un fonctionnement connu ces réseaux sont configurés pour diffracter une onde évanescente qui est absorbée par la couche AL2.

Pour SB2 correspondant au LWIR, et pour un détecteur sur substrat GaSb, typiquement une couche AL2 en QCD est préférée au QWIP du fait d'un fort offset de la bande de conduction.

Selon une première sous variante de la deuxième variante la première couche absorbante AL1 est continue, tel qu'illustré figures 7 à 9. La technologie est alors simplifiée et on n'est pas obligé de choisir une couche AL1 compatible d'une structure en mésa. Préférentiellement la première couche absorbante AL1 réalise une détection inter bande.

Pour SB1 correspondant au MWIR, et un détecteur sur substrat GaSb, typiquement on privilégie une couche AL1 de type nBn InAsSb planaire. A noter que cette configuration peut fonctionner sans méta surface 13.

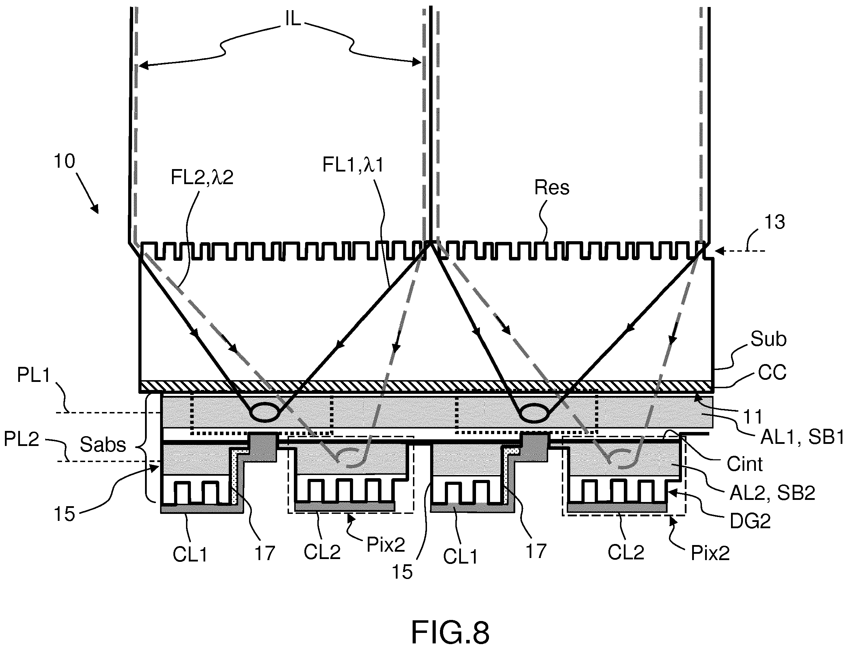

Ce type d'architecture AL1 continue/AL2 en mésa permet de réaliser une prise de contact simplifiée, tel qu'illustré figures 7 et 8.

Selon un mode de réalisation on utilise une structure en mesa d'un deuxième pixel Pix2 sur deux comme pilier 15 sur lequel est déposé une couche isolante 17 puis un contact CL1. La couche isolante 17 isole le mésa du contact CL1. Cette structure en mésa 15 n'est donc pas utilisée comme pixel de détection Pix2, elle sert de support à un contact CL1. Un contact intermédiaire Cint est réalisé entre AL1 et AL2, et le contact CL1 est pris avec la couche AL1 au travers du contact intermédiaire Cint via un trou 19. Le contact CL1 s'étend donc depuis le sommet du mésa 15 jusqu'au trou 19 vers la couche AL1.

La diode de détection d'un pixel Pix1 est donc réalisée entre le contact commun CC et CL1, tandis que la diode de détection d'un pixel Pix2 est réalisée entre le contact intermédiaire Cint et CL2, le contact Cint faisant office de contact commun pour les pixels Pix2. Rappelons que chaque pixel de la matrice doit avoir un contact commun et un contact individuel.

On rapporte ainsi les premiers contacts CL1 sur sensiblement un même plan horizontal que les deuxièmes contacts CL2, ce qui simplifie grandement le raccordement de la partie détection du détecteur au circuit de lecture (hybridation standard). Cette configuration des contacts est rendue possible par la focalisation sélective réalisée par la meta-surface 13, sans elle le signal électrique proviendrait d'une zone trop étendue, générant une diaphonie rédhibitoire.

La première sous variante est compatible d'un agencement des meta-lentilles en décalé comme illustré figure 7 et d'un agencement des meta-lentilles en superposé comme illustré figure 8. Dans cette dernière configuration de la figure 8, on a donc cohérence spatiale entre les deux images détectées, et un agencement de type « dilué » des pixels tel qu'illustré figure 6 est préconisé.

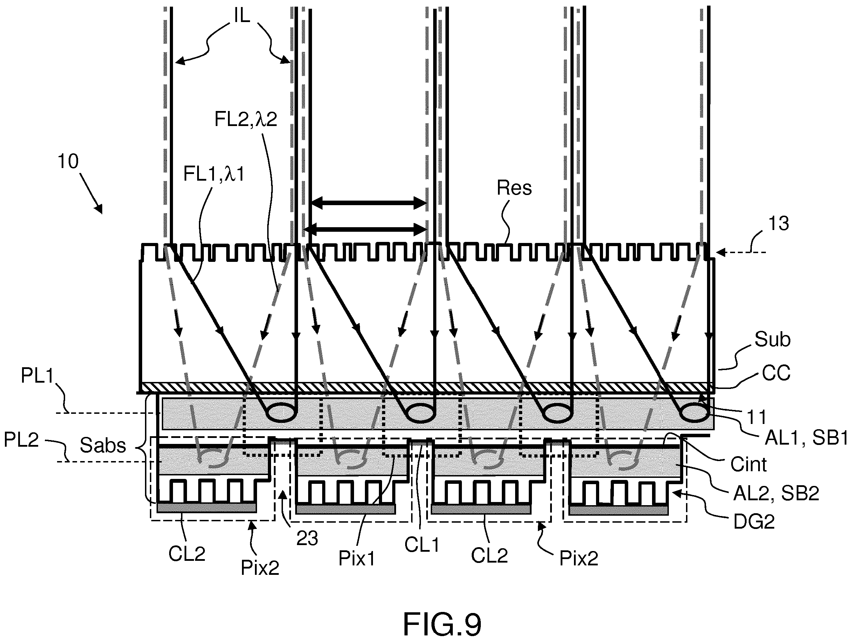

Selon un autre mode de réalisation de la première sous variante AL1 continue/AL2 en mésa tous les mésa de Pix2 sont utilisés comme pixel de détection et recouverts d'un contact CL2, tel qu'illustré figure 9. Dans ce cas le contact CL1 reste localisé au niveau du fond de l'espace inter-mésa 23, et il faudra venir chercher ce contact de la même manière que ce qui est fait pour le détecteur de l'état de la technique illustré figure 1 (cette remontée du contact n'est pas représentée).

Cette architecture a cependant l'avantage de présenter la plus haute résolution spatiale des différentes variantes de l'invention, tout en garantissant une FTM améliorée par rapport à l'état de l'art.

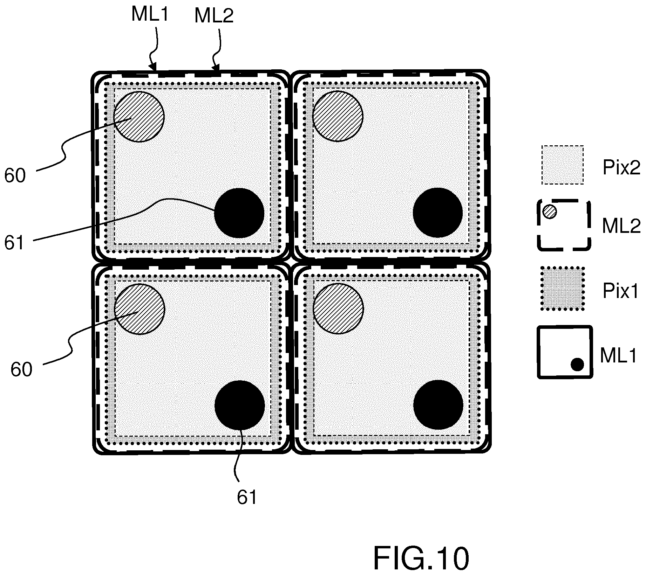

Cette architecture combinée au mode superposé des meta-lentilles est compatible avec une architecture dite dense des pixels illustrée figure 10 dans laquelle la dimension de Pix1 et Pix2 est sensiblement égale à celle des meta-lentilles, lentilles et pixels étant tous superposés. Plus précisément les endroits où sont collectés les porteurs sont décalés entre Pix1 et Pix2, mais les contacts électriques définissant les pixels électriques sont superposés.

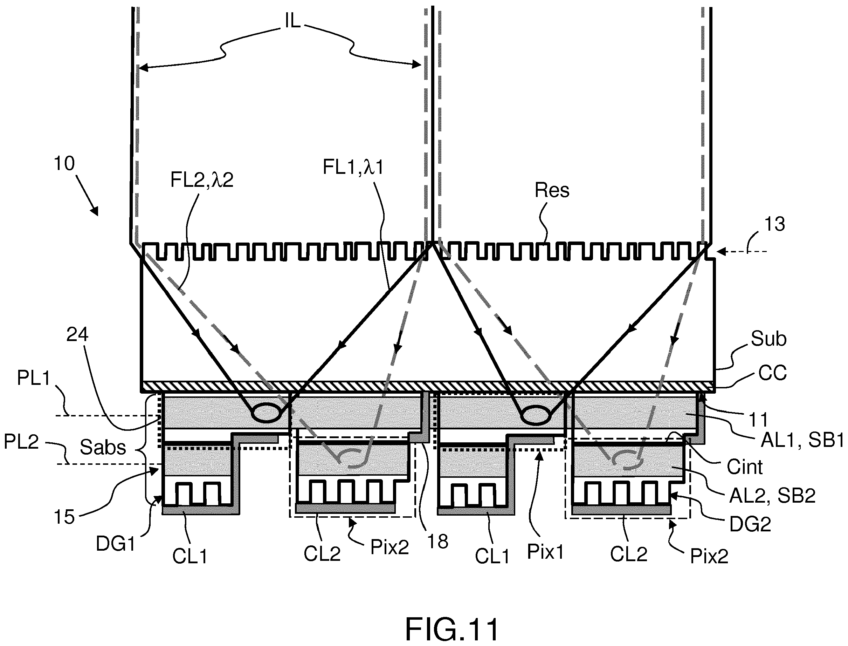

Selon une deuxième sous variante de la deuxième variante la première couche absorbante AL1 est discontinue et gravée de sorte que chaque premier pixel Pix1 présente une structure en mésa servant de base à la structure en mésa du deuxième pixel Pix2. Cette structure en double mésa est illustrée figure 11. Ici la couche AL1 est préférentiellement également de type ISB comme la couche AL2. Cette structure double mésa est compatible d'un agencement superposé des meta-lentilles de la meta-surface 13 garantissant la cohérence spatiale (illustré figure 11) et d'un agencement décalé non illustré.

Selon un mode de réalisation une structure en mesa d'un deuxième pixel sur deux est utilisée comme pilier 15 de manière à rapporter le premier contact CL1 sur sensiblement un même plan horizontal que le deuxième contact CL2. La couche AL1 est divisée en un sous ensemble de premiers mésas, mais seul un premier mésa sur deux 24 est utilisé pour réaliser un pixel opérationnel Pix1. Le deuxième mésa 15 structurant la couche AL2 et disposé au dessus de ce premier mésa 24 sert alors de pilier pour le contact CL1, et n'est donc pas un pixel de détection Pix2.

Selon une option un pixel Pix1 opérationnel comprend un réseau de diffraction DG1 configuré pour diffracter en réflexion le premier faisceau FL1. Le premier mésa disposé en dessous d'un pixel Pix2 opérationnel n'est pas utilisé non plus pour la détection. Le contact intermédiaire Cint entre AL2 et AL1 est, pour ce double mésa, relié au contact commun via la couche 18.

Le contact CL1 d'un pixel Pix1 opérationnel s'étend du sommet du mésa 15 au sommet restant libre du premier mésa lui servant de base.

La diode de détection d'un pixel Pix1 est donc réalisée entre le contact commun CC et CL1, tandis que la diode de détection d'un pixel Pix2 est réalisée entre le contact intermédiaire Cint relié au contact commun et CL2. Cette structure double mésa est compatible d'un agencement « dilué » des pixels, et d'un agencement « dense », ce dernier étant cependant difficile à réaliser. En effet dans ce cas il faut perdre une partie de la surface de Pix2 pour ramener le contact Cint sur le plan de CL2 au niveau de chaque pixel. On revient à la difficulté d'hybridation évoquée dans l'état de la technique.

## Revendications

1. Détecteur optique (10) sensible dans au moins deux plages de longueur d'onde infrarouges dénommées première bande spectrale (SB1) et deuxième bande spectrale (SB2), et présentant un ensemble de pixels, comprenant :
- une structure absorbante (Sabs) disposée sur une face inférieure (11) d'un susbtrat (Sub) et comprenant un empilement d'au moins une couche absorbante (AL, AL1, AL2) en matériau semi-conducteur, sensible dans les deux bandes spectrales (SB1, SB2) et apte à photo-générer des porteurs par absorption d'un faisceau (IL) incident sur une face supérieure (12) dudit substrat,
la structure absorbante étant en outre reliée à un circuit de lecture par au moins un ensemble de contacts (CL1, CL2) associés auxdits pixels,
- le détecteur comprenant en outre une pluralité de résonateurs diélectriques (Res) sur la face supérieure (12) dudit substrat formant une surface supérieure dénommée meta-surface (13),
la meta-surface étant configurée pour diffuser, défléchir et focaliser dans les pixels du détecteur de manière résonnante, lorsqu'éclairée par la lumière incidente (IL), un premier faisceau (FL1) présentant au moins une première longueur d'onde (λ1) comprise dans la première bande spectrale (SB1) et un deuxième faisceau (FL2) présentant au moins une deuxième longueur d'onde (λ2) comprise dans la deuxième bande,
la meta-surface étant en outre configurée pour que lesdits premier (FL1) et deuxième (FL2) faisceaux soient focalisés sur des pixels différents du détecteur.

2. Détecteurs selon la revendication 1 dans lequel la première bande spectrale (SB1) est comprise dans la bande 3-5 µm (MWIR) et la deuxième bande spectrale est comprise dans la bande 8-12 µm (LWIR).

3. Détecteur selon l'une des revendications précédentes dans lequel l'empilement comprend une seule couche absorbante (AL) sensible à la fois dans la première et la deuxième bande spectrale,
le premier faisceau (FL1) étant focalisé sur un premier sous ensemble de pixels dénommés premiers pixels (Pix1), et le deuxième faisceau (FL2) étant focalisé sur un deuxième sous ensemble de pixels dénommés deuxièmes pixels (Pix2), lesdits premier et deuxième pixels étant disposés dans un même plan.

4. Détecteur selon l'une des revendications 1 ou 2 dans lequel ledit empilement comprend une première couche absorbante (AL1) sensible dans la première bande spectrale (SB1) et disposée dans un premier plan (PL1), et une deuxième couche absorbante (AL2) sensible dans la deuxième bande spectrale (SB2) et disposée dans un deuxième plan (PL2) différent du premier plan, la première couche absorbante étant la plus proche du substrat,
le premier faisceau (FL1) étant focalisé sensiblement dans le premier plan (PL1) sur un premier sous ensemble de pixels dénommés premiers pixels (Pix1), et le deuxième faisceau (FL2) étant focalisé sensiblement dans le deuxième plan (PL2) sur un deuxième sous ensemble de pixels dénommés deuxièmes pixels (Pix2).

5. Détecteur selon la revendication précédente dans lequel la deuxième couche absorbante (AL2) est discontinue et gravée de sorte qu'un deuxième pixel (Pix2) présente une structure en mésa.

6. Détecteur selon la revendication précédente dans lequel la deuxième couche absorbante (AL2) réalise une détection inter sous bande (ISB).

7. Détecteur selon l'une des revendications 5 ou 6 dans lequel un deuxième pixel (Pix2) comprend un réseau de diffraction (DG2) configuré pour diffracter en réflexion le deuxième faisceau (FL2).

8. Détecteur selon l'une des revendications 4 à 7 dans lequel la première couche absorbante (AL1) est continue.

9. Détecteur selon l'une des revendications 4 à 8 dans lequel la première couche absorbante (AL1) réalise une détection inter bande.

10. Détecteur selon l'une des revendications 5 à 9 dans lequel chaque premier pixel (Pix1) est relié à un premier contact (CL1) et chaque deuxième pixel (Pix2) est relié à un deuxième contact (CL2), et dans lequel une structure en mesa d'un deuxième pixel sur deux est utilisée comme pilier (15) de manière à rapporter les premiers contacts (CL1) sur sensiblement un même plan horizontal que les deuxièmes contacts (CL2).

11. Détecteur selon l'une des revendications 5 à 7 dans lequel chaque premier pixel (Pix1) est relié à un premier contact (CL1) et chaque deuxième pixel (Pix2) est relié à un deuxième contact (CL2), et dans lequel la première couche absorbante (AL1) est discontinue et gravée de sorte que chaque premier pixel (Pix1) présente une structure en mésa servant de base à la structure en mésa du deuxième pixel (Pix2).

12. Détecteur selon la revendication 11 dans lequel une structure en mesa d'un deuxième pixel sur deux est utilisée comme pilier (15) de manière à rapporter le premier contact (CL1) sur sensiblement un même plan horizontal que le deuxième contact (CL2).

13. Détecteur selon l'une des revendications précédentes dans lequel on définit une première meta-lentille (ML1) comme la fraction de la meta-surface focalisant le premier faisceau dans un premier pixel associé, et une deuxième meta-lentille (ML2) comme la fraction de la meta-surface focalisant le deuxième faisceau dans un deuxième pixel associé, et dans lequel la meta-surface est configurée de sorte que les premières et les deuxièmes meta-lentilles soient décalées l'une par rapport à l'autre.

14. Détecteur selon l'une des revendications 1 à 12 dans lequel on définit une première meta-lentille (ML1) comme la fraction de la metasurface focalisant le premier faisceau dans un premier pixel associé, et une deuxième meta-lentille (ML2) comme la fraction de la metasurface focalisant le deuxième faisceau dans un deuxième pixel associé, et dans lequel la meta-surface est configurée de sorte que les premières et deuxième meta-lentilles soient superposées.

15. Détecteur selon l'une des revendications 13 ou 14 dans lequel la somme des surfaces respectives d'un premier et d'un deuxième pixel est inférieure ou égale à la surface d'une meta-lentille.

## Patentansprüche

1. Optischer Detektor (10), der in mindestens zwei infraroten Wellenlängenbereichen, erstes Spektralband (SB1) und zweites Spektralband (SB2) genannt, empfindlich ist und einen Satz von Pixeln aufweist, der Folgendes umfasst:
- eine absorbierende Struktur (Sabs), die auf einer Unterseite (11) eines Substrats (Sub) angeordnet ist und einen Stapel aus mindestens einer absorbierenden Schicht (AL, AL1, AL2) aus Halbleitermaterial umfasst, die in den beiden Spektralbändern (SB1, SB2) empfindlich ist und Träger durch Absorption eines auf eine Oberseite (12) des Substrats auftreffenden Strahls (IL) photogenerieren kann,
wobei die absorbierende Struktur ferner durch mindestens einen Satz von mit den Pixeln assoziierten Kontakten (CL1, CL2) mit einer Leseschaltung verbunden ist,
- wobei der Detektor ferner eine Vielzahl von dielektrischen Resonatoren (Res) auf der Oberseite (12) des Substrats umfasst, die eine Meta-Oberfläche (13) genannte obere Fläche bilden,
wobei die Meta-Oberfläche zum Streuen, Ablenken und Fokussieren, bei Beleuchtung durch das einfallende Licht (IL), eines ersten Strahls (FL1) mit mindestens einer ersten Wellenlange (λ1) innerhalb des ersten Spektralbandes (SB1) und eines zweiten Strahls (FL2) mit mindestens einer zweiten Wellenlange (λ2) innerhalb des zweiten Bandes in den Pixeln des Detektors auf resonante Weise konfiguriert ist,
wobei die Meta-Oberflache ferner so konfiguriert ist, dass der erste (FL1) und der zweite (FL2) Strahl auf unterschiedliche Pixel des Detektors fokussiert werden.

2. Detektoren nach Anspruch 1, wobei das erste Spektralband (SB1) im 3-5 µm Band (MWIR) und das zweite Spektralband im 8-12 µm Band (LWIR) liegt.

3. Detektor nach einem der vorherigen Ansprüche, wobei der Stapel eine einzelne absorbierende Schicht (AL) umfasst, die sowohl im ersten als auch im zweiten Spektralband empfindlich ist,
wobei der erste Strahl (FL1) auf eine erste Teilmenge von erste Pixel (Pix1) genannten Pixeln fokussiert wird und der zweite Strahl (FL2) auf eine zweite Teilmenge von zweite Pixel (Pix2) genannten Pixeln fokussiert wird, wobei die ersten und zweiten Pixel in derselben Ebene angeordnet sind.

4. Detektor nach Anspruch 1 oder 2, wobei der Stapel eine erste absorbierende Schicht (AL1), die im ersten Spektralband (SB1) empfindlich und in einer ersten Ebene (PL1) angeordnet ist, und eine zweite absorbierende Schicht (AL2) umfasst, die im zweiten Spektralband (SB2) empfindlich und in einer zweiten Ebene (PL2) angeordnet ist, die sich von der ersten Ebene unterscheidet, wobei die erste absorbierende Schicht dem Substrat am nächsten ist,
wobei der erste Strahl (FL1) im Wesentlichen in der ersten Ebene (PL1) auf eine erste Teilmenge von erste Pixel (Pix1) genannten Pixeln fokussiert wird und der zweite Strahl (FL2) im Wesentlichen in der zweiten Ebene (PL2) auf eine zweite Teilmenge von Pixel (Pix2) genannten Pixeln fokussiert wird.

5. Detektor nach dem vorherigen Anspruch, wobei die zweite absorbierende Schicht (AL2) diskontinuierlich und geätzt ist, so dass ein zweites Pixel (Pix2) eine Mesa-Struktur aufweist.

6. Detektor nach dem vorherigen Anspruch, wobei die zweite absorbierende Schicht (AL2) eine Inter-Subband-Detektion (ISB) durchführt.

7. Detektor nach einem der Ansprüche 5 oder 6, wobei ein zweites Pixel (Pix2) ein Beugungsgitter (DG2) umfasst, das zum Beugen des zweiten Strahls (FL2) in Reflexion konfiguriert ist.

8. Detektor nach einem der Ansprüche 4 bis 7, wobei die erste absorbierende Schicht (AL1) kontinuierlich ist.

9. Detektor nach einem der Ansprüche 4 bis 8, wobei die erste absorbierende Schicht (AL1) eine Interband-Detektion durchführt.

10. Detektor nach einem der Ansprüche 5 bis 9, wobei jedes erste Pixel (Pix1) mit einem ersten Kontakt (CL1) verbunden ist und jedes zweite Pixel (Pix2) mit einem zweiten Kontakt (CL2) verbunden ist, und wobei eine Mesa-Struktur jedes zweiten zweiten Pixels als Pfeiler (15) verwendet wird, um die ersten Kontakte (CL1) im Wesentlichen auf eine gleiche horizontale Ebene wie die zweiten Kontakte (CL2) zu bringen.

11. Detektor nach einem der Ansprüche 5 bis 7, wobei jedes erste Pixel (Pix1) mit einem ersten Kontakt (CL1) verbunden ist und jedes zweite Pixel (Pix2) mit einem zweiten Kontakt (CL2) verbunden ist, und wobei die erste absorbierende Schicht (AL1) diskontinuierlich und geätzt ist, so dass jedes erste Pixel (Pix1) eine Mesa-Struktur aufweist, die als Basis für die Mesa-Struktur des zweiten Pixels (Pix2) dient.

12. Detektor nach Anspruch 11, wobei eine Mesa-Struktur jedes zweiten Pixels als Pfeiler (15) verwendet wird, um den ersten Kontakt (CL1) im Wesentlichen auf eine gleiche horizontale Ebene wie den zweiten Kontakt (CL2) zu bringen.

13. Detektor nach einem der vorherigen Ansprüche, wobei eine erste Metalinse (ML1) als der Bruchteil der Metaoberflache, der den ersten Strahl in einem ersten assoziierten Pixel fokussiert, definiert wird und eine zweite Metalinse (ML2) als der Bruchteil der Metaoberflache, der den zweiten Strahl in einem zweiten assoziierten Pixel fokussiert, definiert wird und wobei die Metaoberflache so konfiguriert ist, dass die erste und die zweite Metalinse relativ zueinander versetzt sind.

14. Detektor nach einem der Ansprüche 1 bis 12, wobei eine erste Metalinse (ML1) als der Bruchteil der Metaoberfläche, der den ersten Strahl in einem ersten assoziierten Pixel fokussiert, definiert wird und eine zweite Metalinse (ML2) als der Bruchteil der Metaoberfläche, der den zweiten Strahl in einem zweiten assoziierten Pixel fokussiert, definiert wird und wobei die Metaoberfläche so konfiguriert ist, dass die erste und die zweite Metalinse übereinander liegen.

15. Detektor nach einem der Ansprüche 13 oder 14, wobei die Summe der jeweiligen Flächen eines ersten und eines zweiten Pixels genauso groß wie oder kleiner als die Oberfläche einer Metalinse ist.

## Claims

1. An optical detector (10) sensitive in at least two infrared wavelength ranges called first spectral band (SB1) and second spectral band (SB2), and having a set of pixels, comprising:
- an absorbent structure (Sabs) disposed on a bottom face (11) of a substrate (Sub) and comprising a stack of at least one absorbent layer (AL, AL1, AL2) made of semiconductor material, sensitive in the two spectral bands (SB1, SB2) and capable of photo-generating carriers by absorption of an incident beam (IL) on a top face (12) of said substrate,
the absorbent structure being further linked to a read-out circuit by at least one set of contacts (CL1, CL2) associated with said pixels,
- the detector further comprising a plurality of dielectric resonators (Res) on the top face (12) of said substrate forming a top surface called meta-surface (13),
the meta-surface being configured to diffuse, deflect and focus in the pixels of the detector in a resonant manner, when lit by the incident light (IL), a first beam (FL1) having at least one first wavelength (λ1) lying within the first spectral band (SB1) and a second beam (FL2) having at least one second wavelength (λ2) lying in the second band,
the meta-surface being also configured so that said first (FL1) and second (FL2) beams are focused on different pixels of the detector.

2. The detector according to claim 1, wherein the first spectral band (SB1) lies within the 3-5 µm band (MWIR) and the second spectral band lies within the 8-12 µm band (LWIR).

3. The detector according to one of the preceding claims, wherein the stack comprises a single absorbent layer (AL) sensitive both in the first spectral band and the second spectral band,
the first beam (FL1) being focused on a first subset of pixels called first pixels (Pix1), and the second beam (FL2) being focused on a second subset of pixels called second pixels (Pix2), said first and second pixels being disposed in the same plane.

4. The detector according to one of claims 1 or 2, wherein said stack comprises a first absorbent layer (AL1) sensitive in the first spectral band (SB1) and disposed in a first plane (PL1), and a second absorbent layer (AL2) sensitive in the second spectral band (SB2) and disposed in a second plane (PL2) different from the first plane, the first absorbent layer being closest to the substrate,
the first beam (FL1) being focused substantially in the first plane (PL1) on a first subset of pixels called first pixels (Pix1), and the second beam (FL2) being focused substantially in the second plane (PL2) on a second subset of pixels called second pixels (Pix2).

5. The detector according to the preceding claim, wherein the second absorbent layer (AL2) is discontinuous and etched so that a second pixel (Pix2) has a mesa structure.

6. The detector according to the preceding claim, wherein the second absorbent layer (AL2) produces an inter-subband detection (ISB).

7. The detector according to one of claims 5 or 6, wherein a second pixel (Pix2) comprises a diffraction grating (DG2) configured to diffract the second beam (FL2) in reflection.

8. The detector according to one of claims 4 to 7, wherein the first absorbent layer (AL1) is continuous.

9. The detector according to one of claims 4 to 8, wherein the first absorbent layer (AL1) produces an inter-band detection.

10. The detector according to one of claims 5 to 9, wherein each first pixel (Pix1) is linked to a first contact (CL1) and each second pixel (Pix2) is linked to a second contact (CL2), and wherein a mesa structure of one out of every two second pixels is used as pillar (15) so as to bring the first contacts (CL1) to substantially a same horizontal plane as the second contacts (CL2).

11. The detector according to one of claims 5 to 7, wherein each first pixel (Pix1) is linked to a first contact (CL1) and each second pixel (Pix2) is linked to a second contact (CL2), and wherein the first absorbent layer (AL1) is discontinuous and etched so that each first pixel (Pix1) has a mesa structure serving as base for the mesa structure of the second pixel (Pix2).

12. The detector according to claim 11, wherein a mesa structure of a second pixel in every two is used as pillar (15) so as to bring the first contact (CL1) to substantially a same horizontal plane as the second contact (CL2).

13. The detector according to one of the preceding claims, wherein a first meta-lens (ML1) is defined as the fraction of the meta-surface focusing the first beam in a first associated pixel, and a second meta-lens (ML2) is defined as the fraction of the meta-surface focusing the second beam in a second associated pixel, and wherein the meta-surface is configured so that the first and second meta-lenses are offset with respect to each other.

14. The detector according to one of claims 1 to 12, wherein a first meta-lens (ML1) is defined as the fraction of the meta-surface focusing the first beam in a first associated pixel, and a second meta-lens (ML2) is defined as the fraction of the meta-surface focusing the second beam in a second associated pixel, and wherein the meta-surface is configured so that the first and second meta-lenses are superposed.

15. The detector according to one of claims 13 or 14, wherein the sum of the respective surfaces of a first pixel and of a second pixel is smaller than or equal to the surface of a meta-lens.
